# EUROPEAN PATENT SPECIFICATION

(11) **EP 0 780 925 B1**
(45) Date of publication and mention of the grant of the patent: **11.10.2000**
(21) Application number: 96120251.2
(22) Date of filing: 17.12.1996
(51) Int. Cl.: H01R 4/64, H05K 9/00, H01R 13/658

(54) **Shielding device against electromagnetic disturbances of a plurality of cables**
Abschirmvorrichtung zum Schutz gegen elektromagnetische Störungen einer Mehrzahl von Kabeln
Dispositif de blindage de plusieurs câbles contre les perturbations électromagnétiques

(30) Priority: 22.12.1995 IT MI952730
(43) Date of publication of application: 25.06.1997
(73) Proprietor: Italtel s.p.a., 20154 Milano (IT)
(72) Inventor: Puiu, Adrian, 20152 Milano (IT); Vincenzi, Tiziano, 20094 Buccinasco (MI) (IT)
(74) Representative: Giustini, Delio

(56) References cited:
- GB-A- 2 160 718
- US-A- 3 830 954
- US-A- 4 534 602

## Description

### Field of the invention

The present invention relates to a device to establish an electric contact between the metallic shielding braid of a cable and the metallic mass of a cubicle inside of which electronic or telecommunication equipment is housed in the point where the cable passes through the wall of the cubicle.

In telecommunication systems it is important to assure an adequate drainage towards the mass of the disturbances currents which due to inductive and/or capacitive phenomenons induce on the external conductor or on the metallic shielding braid of cables abutting on said equipment housed inside of metallic shielded cubicles. For this reason it is important to establish a good electric contact between the metallic shielding braid of the cable and the metallic mass of the cubicle in the point where it passes through the metallic wall of the cubicle or where the cable enter the shielded internal space of the cubicle.

When one or more shielded electric cables for the transportation of electrical power or data have to abut inside a shielded cubicle containing equipment which is sensible to electromagnetic disturbances, although in the abutting point the metallic braid wrapping the conductors is electrically connected to the metallic mass of the cubicle, the portion of the shielded cable contained inside the cubicle may constitute an access way for electromagnetic disturbances due to currents circulating in the metallic shielding braid of the cable. Therefore it is important to guarantee an efficient drainage towards the mass of these currents induced in the point in which the cable penetrates inside the shielded space of the cubicle.

### Background Art

Numerous technical solutions are known to realise an adequate electric contact between the metallic shielding braid of a cable and the metallic mass of the cubicle in proximity of the opening provided for the access of the cables into the cubicle. These devices are generally common clamps using screws, tension rods or compression springs.

In the quite frequent case of a particularly great number of shielded cables abutting inside the shielded space different devices have been proposed which are suitable to guarantee an efficient contact of the metallic shielding braid of the cables to assure an electric continuity with respect to the metallic mass of the cubicle in the point where the cables pass through the metallic shielding wall of the cubicle.

The actually known devices are based on the use of special clamps in which one or more jaws to be moved along a shifting direction substantially orthogonal to the axis of the shielded cables tighten a plurality of shielded cables from which previously the isolating sheath has been locally removed uncovering the respective metallic shielding braid. Commonly several shielded cables are tightened together forcing the mobile jaw of the clamp in this way to assure through the metallic structure of the clamp the electric continuity with the metallic wall of the cubicle adjacent to the opening for the passage of the cables.

The Italian patent application Nr. IT 1279091B filed on Dec. 11, 1995 in the name of the same applicant describes a particularly efficient solution of this type of blocking and contact clamping of the metallic shielding braids of the cables entering in a shielded space.
In the US patent Nr. 3.830.954 published on Aug. 20, 1974 another type of multiple blocking and contact clamp is described suitable to receive a certain number of shielded cables, characterized in that a series of profiled inserts of a deformable material and electrically conductive such for example a foam or a sponge of a conductive elastomer can be compressed acting on a compression cross member activated by a clamping screw.

The common architecture of these devices is the use of a clamp with orthogonal working compared to the axis of the shielded cables.

If inserts, gaskets or jaws of conductive elastomer are used to maintain the cables orderly spaced among them, despite the spongy conductive material or anyhow elastomer is compressed by the compression cross member activated by a screw in order to tighten around the metallic shielding braid of the cables, the course of the drainage flows towards the metallic mass of the cubicle may turn out excessively resistive, especially if conductive sponges or elastomer with a relatively high resistivity bulk are used. Moreover the construction of the multiple clamping system using one or more compression cross members with orthogonal shifting with respect to the axis of the cables turns out to be rather complex. In fact further to require suitable artifices to assure a shielding coverage of the complete opening made through the metallic wall of the cubicle, and to guarantee electric drainage courses towards the metallic mass of the cubicle through multiple contacts which occur between the metallic shielding braid of the cable, the gasket or elastic conductive jaw, the compression cross members, the shifting frame of the compression cross members, and between this and the metallic wall adjacent to the opening for the passage of the cables.

### Object of the Invention

The main object of the present invention is to overcome in an efficient way the difficulties and drawbacks of the known systems.

### Summary of the Invention

The device according to the invention may be realized by a limited number of parts. It comprises essentially a perforated body made of conductive elastomer, such as a spongy foam of conductive elastomer material or also a non foamed conductive elastomer material provided with a plurality of parallel holes with a diameter suitable for the passage of a shielded cable (after having locally unwrapped its external isolating sheath). A metallic perforated panel or board, which may be mechanically or electrically connected in a direct way to the metallic wall of the cubicle so that it recovers completely the opening made through the wall for the passage of the cables, is provided with holes which are essentially coaxial to the holes of the elastomer body which lies with one face directly on one plane face of the perforated metallic board. The device is completed by at least one compression counterboard, which is also provided with hole essentially coaxial to the holes of the metallic board and of the elastomer body which acts against the opposed face of the elastomer body.

The assemblage is carried out by inserting freely the cables through the (coaxial) holes of the metallic board or panel already fixed or to be fixed directly on the wall of the cubicle, of the conductive elastomer body and of the compression counterboard. Once all cables are inserted the whole set up by the "sandwich" composed by the perforated metallic board, the perforated elastomer body and the compression counterboard passed through by the cables is tightened by acting on specific tie rods in order to bring the perforated compression counterboard closer to the perforated metallic board (fixed or to be fixed on the wall of the cubicle) compressing the interposed perforated body of conductive elastomer, which undergoes due the compression a deformation such to clench on the metallic shielding braid of the cables passing through the parallel holes.

The compression means may be simple threaded tie rods passing through tubular spacers which define a correct limit of compression of the perforated elastomer body between both boards. In practice the contact surface between the perforated elastomer body and the perforated metallic board which are electrically connected to the metallic wall of the cubicle represents a contact area distributed on the total opening for the passage of the cables or immediately adjacent to each hole for the passage of the respective cables in order to guarantee electric drainage courses with low resistivity for all cables, independently from their relative position compared to the dimensions of the passage opening or of the opening made through the metallic wall of the shielding cubicle.

Therefore in addition to the need of a reduced number of components and an extremely simplified construction compared to the known devices, the device according to the invention assures a great uniformity and a low resistance of the drainage current courses for all shielded cables passing through the wall.

### Brief Description of the Drawings

The features of the present invention are set forth with particularity in the appended claims. The invention, together with further objects and advantages thereof, may be understood with reference to the following description, taken in conjunction with the accompanying drawings and in which:
Figure 1 is an exploded view of the anchorage and contact device according to the invention;
Figure 2 shows in an exploded way the assemblage steps of the device;

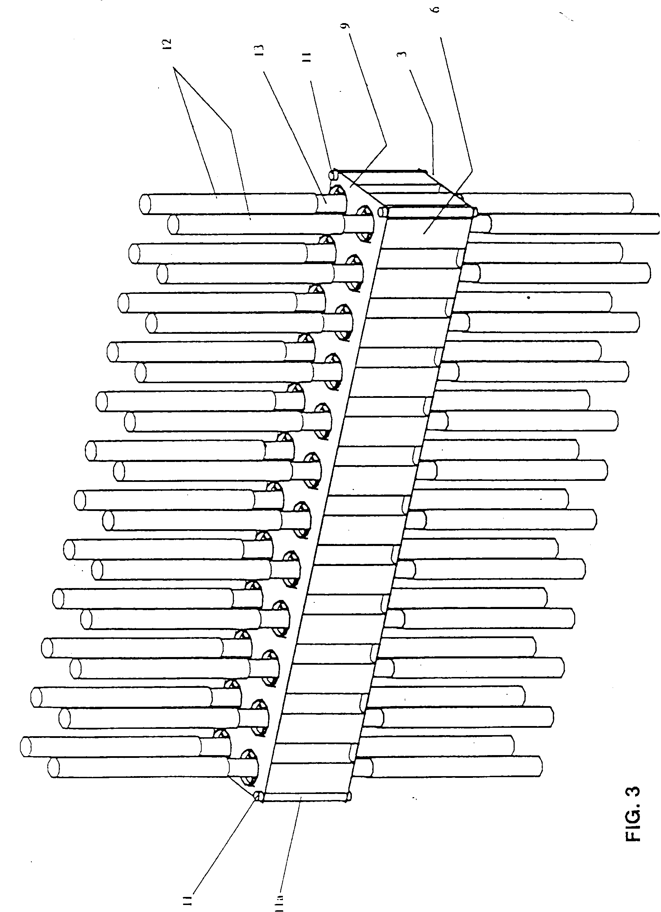

Figure 3 is a partial view of the device after its assemblage.

### Detailed Description of a Preferred Realization Example

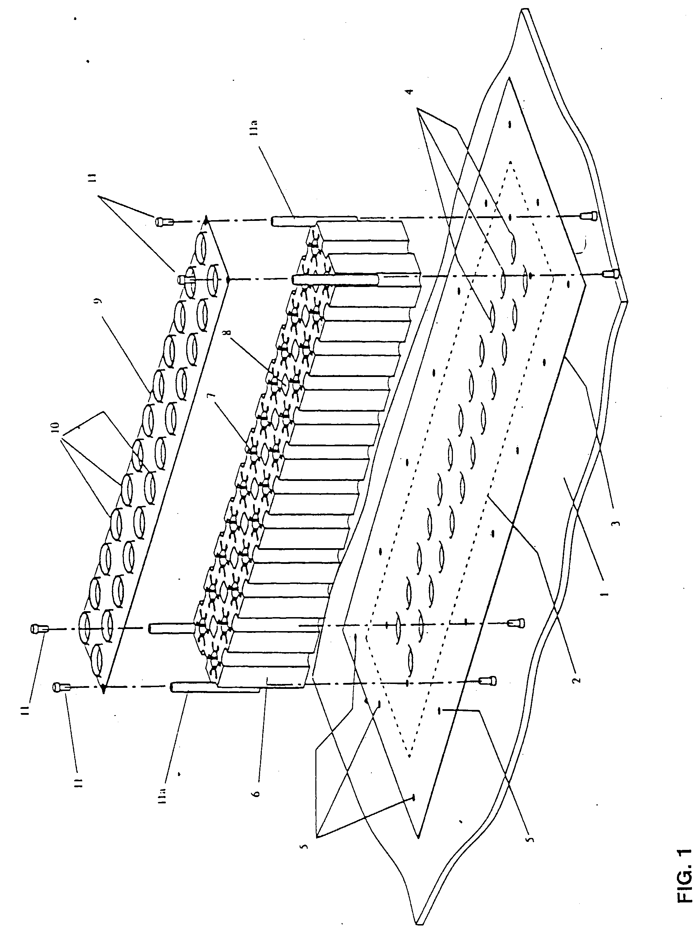

Referring to the exploded view of Fig. 1, this shows in a fragmentary way a rectangular opening 2 set up in the metallic wall 1 of a metallic shielding cubicle for the passage of shielded cables which have to abut inside of the shielded space of the cubicle. The opening 2 made through the wall 1 of the cubicle is completely covered by a perforated metallic panel or board 3. The board 3 has been previously provided with an alignment of holes 4 with a diameter which is sufficient for the passage of shielded cables. the metallic panel or board 3 may possibly be fixed mechanically and in close electric contact to the metallic wall 1 of the cubicle through a plurality of self-threading screws or bolts passing through holes 5 distributed along the coupling perimeter between the board 3 and the wall 1.

A block or parallelepipedon 6 may be cut to measure from a piece of conductive elastomer, for example a spongy foam of an elastomer material charged with conductive fibres or particles in order to assure a certain electric conductivity to the mass of elastomer and provided with parallel preferably grooved holes 7 orderly disposed and which turn out to be essentially coaxial to the holes 4 of the metallic board 3.

The material or carpet from which the parallelepiped block 6 is obtained may be advantageously provided with a second row of holes 8 through the centre line plane where the material may be cut out in function of the required measures.

A counterboard 9 is provided with a perforation 10 in a coordinate way analogous to the perforation 4 of the metallic board 3. Also in this case the holes 10 of the counterboard 9 turn out to be coaxial to the respective grooved holes 7 of the elastomer block 6 and of the holes 4 of the metallic board 3. Four tie rods 11 make it possible to compress the whole like a sandwich.

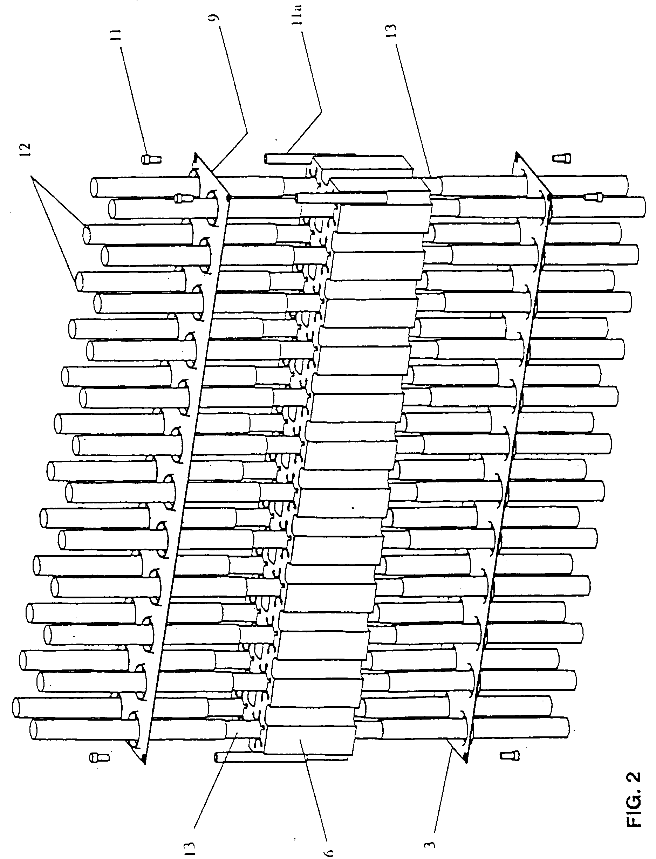

Fig. 2 shows the phase of assemblage of the device which comprises the insertion of the cables 12 sequentially through one and the other of the perforated boards 9 and 3 and through the corresponding grooved holes 7 of the elastomer body 6, obviously unwrapping before the isolating sheath of the cables on the length passing through the grooved holes 7 of the conductive elastomer body 6.

After the definite positioning it is sufficient to tighten the tie rods 11 until the fixed limit from the spacers 11a. In this way the elastomer material of the perforated parallelepiped block 6 is compressed causing a certain degree of deformation which makes the material clenching on the metallic shielding braid 13 of the cables passing through grooved holes 7. Contemporaneously the conductive elastomer block 6 is compressed against the perforated metallic board 3 creating in this way a good electric contact uniformly distributed on the entire support surface and substantially in proximity of the contact area of the elastomer material with the shielding braid of each cable. In practice, the perforated metallic board 3 which is electrically connected to the metallic wall of the cubicle acts like a collector of possible induced currents on the shielding braid of the different passing cables which are in this way efficiently drained towards the metallic mass of the cubicle 1.

Naturally the perforated compression counterboard 9 may also be of metal and contribute through the tie rods to further reduce the resistance of the drainage courses towards the mass of the induced currents on the external shielding conductors of the cables.

Carpets of perforated elastomer material with different dimensional characteristics and in particular with different diameters of the holes for the passage of the cables and/or provided with conical shaped holes, and an analogous inventory of perforated boards make it possible to realize devices of different dimensions and quantities of cables, simplifying the storage problems and contributing also for the reduction of manufacturing costs of the parts setting up the device.

While a particular embodiment of the present invention has been shown and described, it should be understood that the present invention is not limited thereto since other embodiments may be made by those skilled in the art. It is thus contemplated that the present invention encompasses any and all such embodiments covered by the following claims.

## Claims

1. Shielding device suitable to prevent disturbances of the electromagnetic type for shielded cables abutted on electric and telecommunication equipment housed inside a metallic cubicle and suitable to establish an electric contact between the metallic shielding braid of the cables and the metallic mass of the cubicle, substantially in the point where the cables enter the internal shielded space through an opening made in said metallic cubicle, comprising :
a perforated body of conductive elastomer with a plurality of parallel holes, each one suitable for the passage of a shielded cable from which the external isolating sheath has previously and locally been unwrapped;
at least one perforated metallic board which can be electrically connected to said metallic wall of the cubicle suitable to let said cables pass through holes which are substantially coaxial to the holes of said elastomer body, and said board is put into contact with one face of said elastomer body;
at least one perforated counterboard suitable for the passage of said cables through holes which are substantially coaxial to the holes of said elastomer body and to said metallic board acting on the opposed face of said elastomer body;
means suitable to compress said conductive elastomer body between said metallic board and said counterboard causing a deformation of the elastomer body which can be sufficient to clench said cables passing inside said holes and can contact in this way the shielding braid.

2. Device according to claim 1, characterized in that also said perforated counterboard is made of metal.

3. Device according to claim 1, characterized in that said perforated metallic board extends in such way to cover completely the opening in the cubicle through which the cables enter the internal shielded space.

4. Device according to claim 1, characterized in that said compression means include a plurality of tubular spacers suitable to limit the compression course of said elastomer body between said board and said counterboard and tie rods passing through said spacers which can be tightened on the face opposed to said perforated board and said counterboard.

5. Device according to claim 1, characterized in that the holes provided for in said conductive elastomer body have different diameters.

6. Device according to claim 1, characterized in that the holes provided for in said elastomer conductor are conically shaped.

## Patentansprüche

1. Abschirmungseinrichtung, die sich dazu eignet, Störungen des elektromagnetischen Typs für abgeschirmte Kabel zu verhindern, die an in einem metallischen Schaltschrank untergebrachte elektrische und Telekommunikationsgeräte angrenzen, und die sich dazu eignet, einen elektrischen Kontakt zwischen der metallischen Abschirmungslitze der Kabel und der metallischen Masse des Schaltschranks im wesentlichen an dem Punkt herzustellen, an dem die Kabel durch eine in dem metallischen Schaltschrank hergestellte Öffnung in den inneren abgeschirmten Raum eintreten, umfassend:
einen durchlöcherten Körper aus leitendem Elastomer mit mehreren parallelen Löchern, die sich jeweils für den Durchgang eines abgeschirmten Kabels eignen, von dem der äußere Isoliermantel zuvor und örtlich abgewickelt worden ist;
mindestens eine durchlöcherte metallische Platte, die elektrisch mit der metallischen Wand des Schaltschranks verbunden werden kann und sich dazu eignet, die Kabel durch Löcher treten zu lassen, die im wesentlichen koaxial zu den Löchern des Elastomerkörpers sind, und wobei die Platte mit einer Fläche des Elastomerkörpers in Kontakt gebracht wird;
mindestens eine durchlöcherte Gegenplatte, die sich für den Durchgang der Kabel durch Löcher eignet, die im wesentlichen koaxial zu den Löchern des Elastomerkörpers und der metallischen Platte sind, die auf die entgegengesetzte Fläche des Elastomerkörpers wirkt;
Mittel, die sich dazu eignen, den leitenden Elastomerkörper zwischen der metallischen Platte und der Gegenplatte zusammenzudrücken, was eine Verformung des Elastomerkörpers bewirkt, die ausreichen kann, um die innerhalb der Löcher durchtretenden Kabel festzuklammern und auf diese Weise die Abschirmungslitze zu kontaktieren.

2. Einrichtung nach Anspruch 1, dadurch gekennzeichnet, daß auch die durchlöcherte Gegenplatte aus Metall hergestellt ist.

3. Einrichtung nach Anspruch 1, dadurch gekennzeichnet, daß sich die durchlöcherte metallische Platte derart erstreckt, daß sie die Öffnung in dem Schaltschrank, durch die die Kabel in den inneren abgeschirmten Raum eintreten, vollständig bedeckt.

4. Einrichtung nach Anspruch 1, dadurch gekennzeichnet, daß das Druckmittel mehrere rohrförmige Abstandshalter enthält, die sich dazu eignen, den Druckabstand des Elastomerkörpers zwischen der Platte und der Gegenplatte zu begrenzen und wobei Zugstangen durch die Abstandshalter gehen, die an der der durchlöcherten Platte und der Gegenplatte abgewandten Fläche angezogen werden können.

5. Einrichtung nach Anspruch 1, dadurch gekennzeichnet, daß die in dem leitenden Elastomerkörper vorgesehenen Löcher unterschiedliche Durchmesser aufweisen.

6. Einrichtung nach Anspruch 1, dadurch gekennzeichnet, daß die in dem Elastomerleiter vorgesehenen Löcher konisch geformt sind.

## Revendications

1. Dispositif de blindage convenant pour empêcher des perturbations du type électromagnétique pour des câbles blindés aboutissant sur un équipement électrique et de télécommunication logé à l'intérieur d'une armoire métallique et convenant pour établir un contact électrique entre la tresse de blindage métallique des câbles et la masse métallique de l'armoire, substantiellement à l'endroit où les câbles entrent dans l'espace blindé interne à travers une ouverture pratiquée dans ladite armoire métallique, comprenant :
un corps perforé d'élastomère conducteur ayant une pluralité de trous parallèles, chacun convenant pour le passage d'un câble blindé dont la gaine isolante externe a été préalablement et localement retirée ;
au moins une plaque métallique perforée qui peut être connectée électriquement à ladite paroi métallique de l'armoire, convenant pour laisser passer lesdits câbles à travers des trous qui sont substantiellement coaxiaux aux trous dudit corps élastomère, et ladite plaque étant mise en contact avec une face dudit corps élastomère ;
au moins une contre-plaque perforée convenant pour le passage desdits câbles à travers des trous qui sont substantiellement coaxiaux aux trous dudit corps élastomère et à ladite plaque métallique, agissant sur la face opposée dudit corps élastomère ;
des moyens convenant pour comprimer ledit corps élastomère conducteur entre ladite plaque métallique et ladite contre-plaque, entraînant une déformation du corps élastomère qui peut suffire pour aplatir lesdits câbles passant à l'intérieur des trous et pour ainsi contacter la tresse de blindage.

2. Dispositif selon la revendication 1, caractérisé en outre en ce que ladite contre-plaque perforée est réalisée en métal.

3. Dispositif selon la revendication 1, caractérisé en ce que ladite plaque métallique perforée s'étend de manière à couvrir complètement l'ouverture dans l'armoire par laquelle les câbles entrent dans l'espace blindé interne.

4. Dispositif selon la revendication 1, caractérisé en ce que lesdits moyens de compression comportent une pluralité d'entretoises tubulaires convenant pour limiter le trajet de compression dudit corps élastomère entre ladite plaque et ladite contre-plaque et des tirants passant à travers lesdites entretoises qui peuvent être serrés sur la face opposée à ladite plaque perforée et à ladite contre-plaque.

5. Dispositif selon la revendication 1, caractérisé en ce que les trous pratiqués dans ledit corps élastomère conducteur ont des diamètres différents.

6. Dispositif selon la revendication 1, caractérisé en ce que les trous pratiqués dans ledit corps élastomère sont de forme conique.
